# FASCICULE DE BREVET EUROPEEN

(11) **EP 3 297 112 B1**
(45) Date de publication et mention de la délivrance du brevet: **30.01.2019**
(21) Numéro de dépôt: 17190733.0
(22) Date de dépôt: 12.09.2017
(51) Int. Cl.: H02H 9/02, G05F 1/56, G01R 1/36

(54) **LIMITEUR DE COURANT POUR CHARGE COURANT ALTERNATIF**
STROMBEGRENZER FÜR WECHSELSTROMLAST
CURRENT LIMITER FOR AC CHARGE

(30) Priorité: 20.09.2016 FR 1658825
(43) Date de publication de la demande: 21.03.2018
(73) Titulaire: COMMISSARIAT À L'ÉNERGIE ATOMIQUE ET AUX ÉNERGIES ALTERNATIVES, 75015 Paris (FR)
(72) Inventeur: ESCOFFIER, René, 38500 LA BUISSE (FR); BOUCHET, Thierry, 38700 CORENC (FR)
(74) Mandataire: GIE Innovation Competence Group

(56) Documents cités:
- EP-A1- 0 895 443
- EP-A2- 0 766 362
- FR-A1- 3 024 010
- FR-A1- 3 028 666
- US-A1- 2013 285 629

## Description

L'invention concerne les circuits de protection de charges électriques à connecter à des réseaux alternatifs, en particulier des circuits de protection face à l'apparition de défaillances comme des court-circuits aux bornes d'une charge électrique.

Le document US5282107 décrit un circuit de protection contre les courts-circuits. Le circuit de protection comprend un redresseur à pont de diodes. La tension alternative est appliquée entre deux bornes d'entrée du pont. Entre les bornes de sortie du pont, un circuit de coupure et un enroulement primaire d'un transformateur sont connectés en série. La charge à protéger est destinée à être connectée aux bornes d'un enroulement secondaire du transformateur. Le circuit de coupure comprend une sonde de mesure de baisse de tension représentative de l'augmentation du courant. La sonde est connectée en série avec un transistor de protection. La mesure de tension est appliquée sur un comparateur. Lorsque la baisse de tension dépasse un seuil, un signal d'ouverture est appliqué sur le transistor de protection.

Un tel circuit de protection présente des inconvénients. D'une part, ce circuit de protection ne permet pas d'assurer une continuité de service en cas de défaillance, la charge n'étant plus alimentée lors de l'ouverture du transistor de protection. D'autre part, la commande est relativement mal protégée contre des défaillances du réseau alternatif, et la charge n'est que partiellement protégée contre des défaillances au niveau de l'enroulement secondaire.

Le document EP0895443 décrit un circuit de protection d'un consommateur électrique. Ce circuit comprend une interface d'entrée comportant des première et deuxième bornes d'entrée pour l'application d'une différence de potentiel alternative, et une interface de sortie comportant des première et deuxième bornes de sortie pour la connexion d'un consommateur électrique. Un capteur de courant est connecté entre la deuxième borne d'entrée et la deuxième borne de sortie. Des premier et deuxième transistors à effet de champ de type MOS normalement fermé sont connectés en série avec le capteur de courant entre la deuxième borne d'entrée et la deuxième borne de sortie, les premier et deuxième transistors étant connectés en série par l'intermédiaire d'un noeud de connexion.

Ce circuit ne permet pas de bien protéger la commande contre des défaillances du réseau alternatif, ni d'assurer une protection optimale de la charge.

Le document US2013/0285629 D2 décrit un circuit de protection connecté à une source continue. Ce circuit inclut un limiteur à double transistors MOS connectés en série, avec des résistances de mesure de courant et un pont de diodes.

Le document EP0766362 décrit un circuit de protection connecté à une source continue. Ce circuit inclut un limiteur utilisant deux transistors MOS à effet de champ pour limiter le courant.

Le document FR3024010 décrit un circuit ayant une connexion en série de 2 transistors HEMT.

Le document FR3028666 décrit un circuit cointégrant plusieurs transistors HEMT.

L'invention vise à résoudre un ou plusieurs de ces inconvénients. L'invention porte ainsi sur un circuit de protection d'un consommateur électrique, tel que défini dans la revendication 1.

L'invention porte également sur les variantes des revendications dépendantes. L'homme du métier comprendra que chacune des caractéristiques des variantes des revendications dépendantes peut être combinée indépendamment aux caractéristiques de la revendication 1, sans pour autant constituer une généralisation intermédiaire.

L'invention porte également sur un circuit de protection d'un consommateur électrique, tel que défini dans les revendications annexées.

D'autres caractéristiques et avantages de l'invention ressortiront clairement de la description qui en est faite ci-après, à titre indicatif et nullement limitatif, en référence aux dessins annexés, dans lesquels :
- la figure 1 est un schéma électrique d'un exemple d'un premier mode de réalisation d'un circuit de protection mis en oeuvre pour la protection d'une charge électrique ;
- la figure 2 est un diagramme illustrant l'influence d'une variante du circuit de protection du premier mode de réalisation sur le courant de sortie en fonction de son activation (échelle grossie sur l'activation et la désactivation);
- la figure 3 est un diagramme illustrant l'influence d'une autre variante du circuit de protection du premier mode de réalisation sur la tension et le courant de sortie en fonction de son activation ;
- la figure 4 est un schéma électrique d'un exemple d'un deuxième mode de réalisation d'un circuit de protection mis en oeuvre pour la protection d'une charge électrique ;
- la figure 5 est un diagramme illustrant l'influence d'une variante du circuit de protection du deuxième mode de réalisation sur le courant de sortie en fonction de son activation ;
- la figure 6 est une figure illustrant schématiquement l'intégration du circuit de protection à partir de transistors à haute mobilité électronique ;
- la figure 7 est un schéma électrique d'un exemple d'un troisième mode de réalisation d'un circuit de protection mis en oeuvre pour la protection d'une charge électrique.

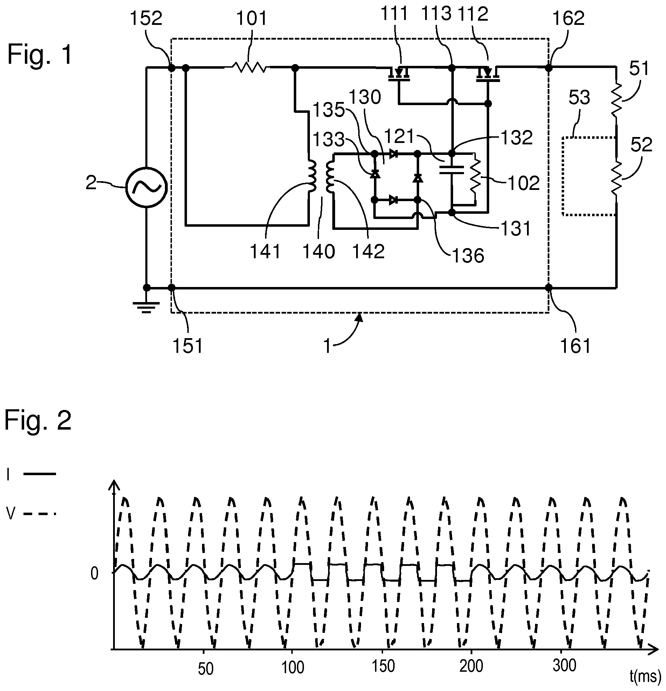

La figure 1 est un schéma électrique d'un exemple d'un premier mode de réalisation d'un circuit de protection 1. Le circuit de protection 1 a une entrée connectée à une source de tension alternative 2, par exemple le réseau alternatif secteur. Le circuit de protection 1 comporte ainsi une entrée comportant des bornes d'entrée 151 et 152. Le circuit de protection 1 a une sortie connectée à un consommateur ou charge électrique 52. Le circuit de protection 1 comporte ainsi une sortie comportant des bornes de sortie 161 et 162. Le circuit de protection 1 peut par exemple être intégré dans une prise de courant domestique, les bornes de sortie 161 et 162 étant par exemple des bornes de sortie pour la connexion d'appareils domestiques, et les bornes d'entrée 151 et 152 étant par exemple des bornes pour la connexion à un tableau électrique par l'intermédiaire de fils de cuivre.

Le circuit de protection 1 comporte un capteur de courant 101 connecté entre la borne d'entrée 152 et la borne de sortie 162. Le capteur de courant 101 est par exemple mis en oeuvre sous la forme d'une résistance dans le mode de réalisation illustré. Le capteur de courant 101 peut également être mis en oeuvre de façon non limitative sous la forme de sonde galvanique ou sous la forme de sonde à effet Hall.

Le circuit de protection 1 comporte également un transistor 111 et un transistor 112 connectés en série avec le capteur de courant 101 entre la borne d'entrée 152 et la borne de sortie 162. Les transistors 111 et 112 sont de type à effet de champ à haute mobilité électronique, de type normalement fermé (ou normalement passant, désigné par N-On). Ces transistors peuvent être remplacés par un seul transistor de type bidirectionnel tel que celui décrit dans le document brevet US20140145203. Le drain du transistor 111 est connecté à la résistance 101. La source du transistor 111 est connectée à la source du transistor 112 par l'intermédiaire d'un noeud de connexion 113. Le drain du transistor 112 est connecté à la borne de sortie 162.

Le circuit de protection 1 comporte un transformateur 140. Un enroulement primaire 141 du transformateur 140 est connecté aux bornes de la résistance 101. Le transformateur 140 comporte par ailleurs un enroulement secondaire 142.

Le circuit de protection 1 comporte également un pont redresseur 130. Le pont redresseur 130 comprend des bornes d'entrée 135 et 136. L'enroulement secondaire 142 est connecté entre ces bornes d'entrée 135 et 136. Le pont redresseur 130 comporte par ailleurs des bornes de sortie 131 et 132, entre lesquelles une charge électrique est connectée. La charge électrique connectée entre les bornes de sortie 131 et 132 est ici un circuit combinant une résistance 102 et un condensateur 121 connectés en parallèle. Le pont redresseur 130 comporte de façon connue en soi quatre diodes de redressement 133, connectées de façon à former un pont de diodes redresseur 130 double alternance.

La grille des transistors 111 et 112 est connectée à la borne de sortie 131 du pont redresseur 130. Le noeud intermédiaire 113 est connecté à la borne de sortie 132 du pont redresseur 130. Le noeud de connexion 113 applique ainsi un potentiel de référence sur la borne de sortie 132. À partir de ce potentiel, un potentiel est appliqué par la borne de sortie 131 sur la grille des transistors 111 et 112.

En fonctionnement normal, les transistors 111 et 112 de type normalement fermé sont conducteurs (sans action extérieure sur la grille) et présentent une résistance de passage extrêmement réduite, du fait de l'utilisation de transistors 111 et 112 à haute mobilité électronique. Ainsi, les pertes dans le circuit de protection 1 en l'absence de défaillance sont extrêmement réduites. Par leur connexion en série, les transistors 111 et 112 forment une connexion bidirectionnelle en courant et en tension pour alimenter le consommateur 52 en alternatif.

Pour limiter les pertes dans le circuit de protection, la résistance 101 présente avantageusement une valeur de résistance au plus égale à 2 Ω, et de préférence égale à 0,5 Ω.

La combinaison de la résistance 101, du transformateur 140, du pont redresseur 130, et de la charge électrique (combinaison de la résistance 102 et du condensateur 121) forment une commande des transistors 111 et 112, en vue de réaliser une limitation de courant.

Une résistance 51 est ici représentative de la résistance de connexion ou de la résistance de ligne jusqu'au consommateur électrique 52. La ligne 53 symbolise un court-circuit contournant le consommateur électrique 52 lors d'une défaillance.

Ainsi, lors de l'apparition d'un court-circuit entre les bornes de sortie 161 et 162 (ou lors de l'apparition d'une surintensité pour toute autre raison entre les bornes 152 et 162, par exemple une décharge d'une inductance sans induire de courant d'arc), le courant à travers la résistance 101 dépasse le courant nominal. Cette surintensité augmente la différence de potentiel aux bornes de la résistance 101. La différence de potentiel appliquée aux bornes de l'enroulement primaire 141 est ainsi accrue, et par conséquent la différence de potentiel aux bornes de l'enroulement secondaire 142 est également accrue. Lorsque la différence de potentiel aux bornes de l'enroulement secondaire 142 dépasse le double de la tension de seuil des diodes 133, une différence de potentiel apparaît entre les bornes 131 et 132, c'est-à-dire aux bornes de la résistance 102 et du condensateur 121. Plus cette différence de potentiel entre les bornes 131 et 132 se rapproche de la tension de seuil des transistors 111 et 112, plus la limitation de courant exercée par les transistors 111 et 112 est importante. Le courant traversant les transistors 111 et 112 assure ainsi à la fois leur commande et leur propre protection par limitation de courant. La commande de grille des transistors 111 et 112 est isolée par l'intermédiaire du transformateur 140, ce qui garantit sa protection. Par ailleurs, ce potentiel est bien référencé par rapport au potentiel du noeud de connexion 113, indépendamment du courant circulant à travers les transistors 111 et 112.

Une telle configuration permet ainsi d'aller à l'encontre d'un a priori technique de l'homme du métier, les transistors à haute mobilité électronique étant considérés comme mal adaptés pour résister à des surintensités (surintensités souvent tolérées pendant une durée inférieure à 10µs), et donc mal adaptés pour une telle application de protection pour les transistors 111 et 112 face à des courts-circuits.

La limitation de courant permet de protéger à la fois le consommateur de courant 52 et la source de tension 2, de façon à pouvoir assurer une continuité de service, au lieu de couper le courant entre les bornes 152 et 162. A la suite du dysfonctionnement, le circuit de protection 1 peut garantir une reprise de fonctionnement normal, la limitation de courant s'interrompant dès que la surintensité à travers le circuit de protection 1 disparaît. Par ailleurs, la défaillance reste malgré tout détectable, de sorte qu'un dispositif de protection disposé par exemple dans un tableau électrique peut prendre une mesure correctrice face à la défaillance. En outre, le circuit de protection 1 permet d'assurer une limitation de courant pour les deux alternances du courant alternatif.

L'utilisation du condensateur 121 permet de relever la valeur de courant de court-circuit, afin de favoriser sa détection dans certaines applications. Le condensateur 121 pourra par exemple présenter une capacité de 10µF, sous forme de composant monté en surface restant relativement facile à inclure dans le circuit intégré 1.

Le transformateur 140 présentera avantageusement un rapport de transformation en tension compris entre 0,5 et 1.

Avantageusement, de façon à conserver une valeur de limitation de courant assez proche du courant nominal et ainsi éviter des risques de détérioration, la tension de seuil des transistors 111 et 112 a avantageusement une amplitude au plus égale à 2V. Sur le diagramme de la figure 2, un fonctionnement normal au courant nominal est observé entre les instants 0 et 100 ms. Entre les instants 100 et 200 ms, un court-circuit est créé entre les bornes de sortie 161 et 162. Avec des transistors 111 et 112 présentant ici une tension de seuil de -1,8V, l'amplitude du courant à travers les transistors 111 et 112 en cas de défaillance reste proche du courant nominal, ici de l'ordre de 110%. Un temps très long est ainsi laissé à d'autres dispositifs de sécurité pour apporter une solution au dysfonctionnement (par exemple une coupure par un disjoncteur ou une déconnexion du consommateur 52). Les simulations ont été effectuées avec une résistance 101 d'une valeur de 0,5 Ω, une résistance 51 d'une valeur de 1 mΩ, une résistance 52 d'une valeur de 10 Ω, une source de tension sinusoïdale 2 de 50V à 50 Hz. Pour un courant de 10 A, la différence de potentiel aux bornes de la résistance 101 est alors de 5 V. Avec un transformateur 140 présentant un rapport de transformation de 1, une même différence de potentiel de 5V est appliquée entre les bornes 135 et 136.

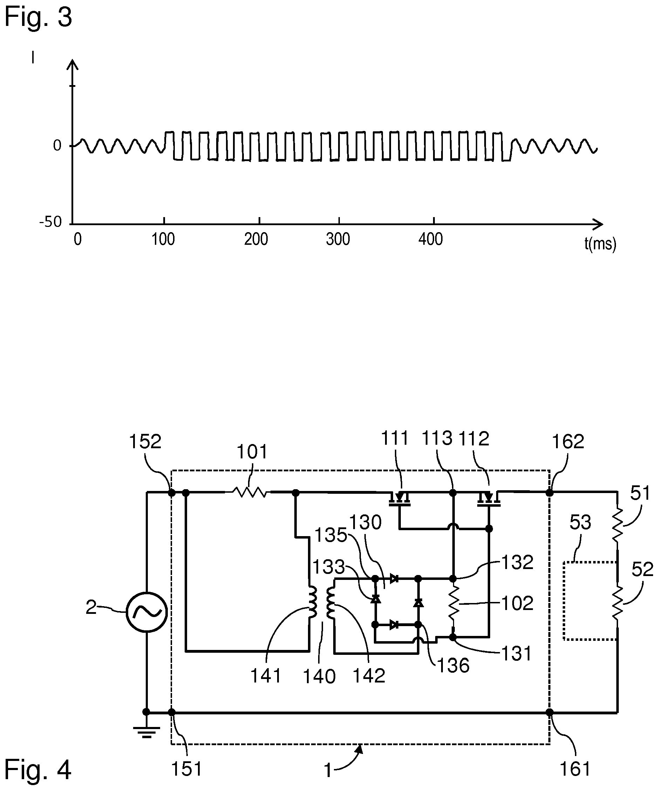

Dans le diagramme illustré à la figure 3, un fonctionnement au courant nominal est également observé entre les instants 0 et 100 ms. Entre les instants 100 ms et 500 ms, un court-circuit est créé entre les bornes de sortie 161 et 162. Dans cette variante du premier mode de réalisation, les transistors 111 et 112 présentent une tension de seuil de -2,8V. L'amplitude du courant à travers les transistors 111 et 112 en cas de défaillance est un peu plus élevée que dans l'exemple de la figure 4, de l'ordre de 170% du courant nominal. La tension de sortie est ici également illustrée, en trait discontinu.

Le noeud de connexion 113 pourra être formé dans une couche de gaz d'électrons continue entre les transistors 111 et 112.

Les transistors 111 et 112 pourront présenter une hétérojonction formée à partir d'une combinaison de couches de matériau de type III-N, incluant par exemple du GaN. Des transistors à base de GaN latéraux sont bien adaptés pour une réalisation symétrique des transistors 111 et 112 partageant une source connectée au noeud de connexion 113.

Avantageusement, les diodes 133 sont chacune constituées d'un transistor à effet de champ à haute mobilité électronique de type normalement ouvert, dont la source et la grille sont connectées. Une telle configuration permet de réaliser des transistors 111 et 112 cointégrés avec le pont redresseur 130 sur un même substrat, afin de bénéficier d'un encombrement et d'un coût de fabrication optimisés. Par ailleurs, dans une telle configuration, la protection par limitation de courant intervient très rapidement, le courant à travers les transistors 111 et 112 assurant leur propre commande par l'intermédiaire d'autres composants cointégrés.

Avantageusement, la résistance 102 est constituée d'un transistor à effet de champ à haute mobilité électronique de type normalement ouvert à tension de seuil négative, dont la source et la grille sont connectées. Une telle configuration permet de réaliser des transistors 111 et 112 cointégrés avec la résistance 102 sur un même substrat, afin de bénéficier d'un encombrement et d'un coût de fabrication optimisés.

Afin de favoriser l'intégration du transformateur 140 dans le circuit intégré 1, celui-ci est de préférence de type planaire superposé.

La figure 4 est un schéma électrique d'un exemple d'un deuxième mode de réalisation d'un circuit de protection 1. Ce deuxième mode de réalisation vise notamment à faciliter l'intégration du circuit de protection 1. Le circuit de protection 1 se différencie de celui du premier mode de réalisation par la structure de la charge électrique connectée entre les bornes de sortie 131 et 132 du pont redresseur 130. Cette charge électrique est ici constituée d'une résistance 102. Comme pour le premier mode de réalisation, la résistance 102 est constituée d'un transistor à effet de champ à haute mobilité électronique de type normalement ouvert à tension de seuil négative, dont la source et la grille sont connectées.

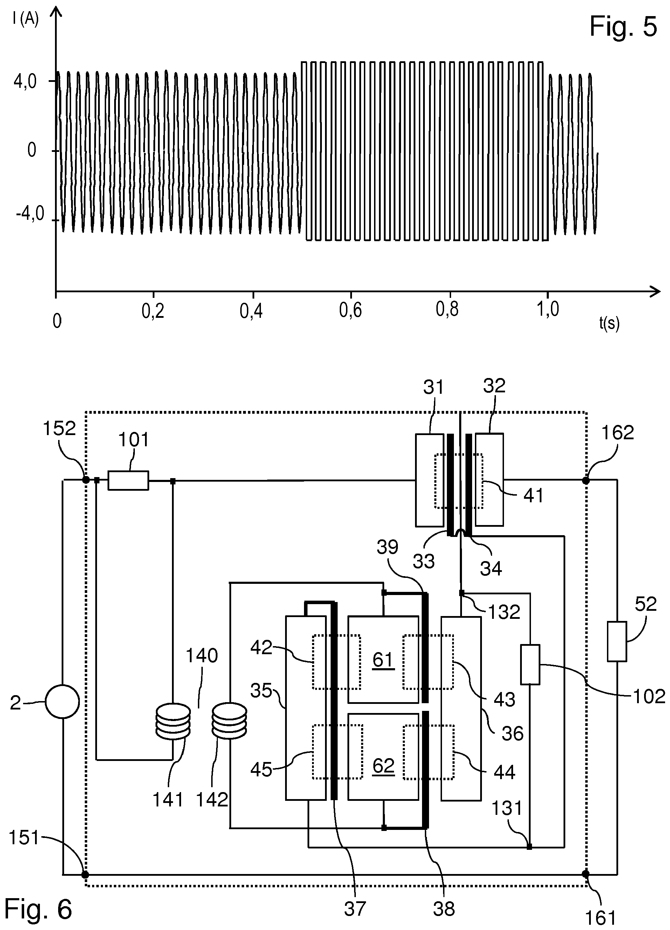

La tension de seuil des transistors 111 et 112 a ici avantageusement une amplitude au plus égale à 2V. Sur le diagramme de la figure 5, un fonctionnement normal au courant nominal est observé entre les instants 0 et 500 ms. Entre les instants 500 et 1000 ms, un court-circuit est créé entre les bornes de sortie 161 et 162. Avec des transistors 111 et 112 présentant ici une tension de seuil de - 1,8V, l'amplitude du courant à travers les transistors 111 et 112 en cas de défaillance reste proche du courant nominal, ici de l'ordre de 110%. Un temps très long est ici également laissé à d'autres dispositifs de sécurité pour apporter une solution au dysfonctionnement. Les simulations ont été effectuées avec une résistance 101 d'une valeur de 0,5 Ω, une résistance 51 d'une valeur de 1 mΩ, une résistance 52 d'une valeur de 10 Ω, une source de tension sinusoïdale 2 de 50V à 50 Hz. Pour un courant de 10 A, la différence de potentiel aux bornes de la résistance 101 est alors de 5 V. Avec un transformateur 140 présentant un rapport de transformation de 1, une même différence de potentiel de 5V est appliquée entre les bornes 135 et 136.

La figure 6 illustre de façon schématique l'intégration d'un circuit de protection 1 selon le premier mode de réalisation, avec une source de tension alternative 2 connectée entre ses bornes d'entrée 151 et 152. Le circuit de protection 1 a une interface de sortie connectée à un consommateur électrique 52.

Une électrode 31 forme un drain du transistor 111 et est connectée au capteur de courant 101. Une électrode 32 forme un drain du transistor 112 et est connectée à la borne de sortie 162. Une couche de gaz d'électrons 41 est connectée par deux extrémités à l'électrode 31 et à l'électrode 32 et s'étend en continu entre ces électrodes 31 et 32. Des électrodes de grille 33 et 34 sont formées à l'aplomb de la couche de gaz d'électrons 41 entre les électrodes 31 et 32. Un noeud de connexion entre les transistors à hétérojonction est intrinsèquement formé dans la couche de gaz d'électrons 41 entre les électrodes de grille 33 et 34. Les électrodes de grille sont connectées à la borne de sortie 31.

Une électrode 35 forme une source commune de deux transistors à hétérojonction connectés en diode. L'électrode 35 est connectée à la borne de sortie 131. Une électrode 36 forme un drain commun de deux autres transistors à hétérojonction connectés en diode. L'électrode 36 est connectée à la borne de sortie 132. On forme ici un pont redresseur à quatre diodes, chacune de ces diodes étant constituée par un transistor à hétérojonction respectif. Une électrode commune 61 forme une électrode commune à deux des transistors à hétérojonction, formant ainsi le drain de l'un, et la source de l'autre. L'électrode 61 est positionnée entre les électrodes 35 et 36. Une autre électrode commune 62 forme une électrode commune à deux des transistors à hétérojonction, formant ainsi le drain de l'un, et la source de l'autre. L'électrode 62 est positionnée entre les électrodes 35 et 36.

Une couche de gaz d'électrons 42 est connectée par deux extrémités à l'électrode 35 et à l'électrode 61 et s'étend en continu entre ces électrodes 35 et 61. Une couche de gaz d'électrons 43 est connectée par deux extrémités à l'électrode 61 et à l'électrode 36 et s'étend en continu entre ces électrodes 61 et 36. Une couche de gaz d'électrons 44 est connectée par deux extrémités à l'électrode 62 et à l'électrode 36 et s'étend en continu entre ces électrodes 62 et 36. Une couche de gaz d'électrons 45 est connectée par deux extrémités à l'électrode 35 et à l'électrode 62 et s'étend en continu entre ces électrodes 35 et 62.

Une électrode de grille 37 est formée à l'aplomb de la couche de gaz d'électrons 42 entre les électrodes 35 et 61. L'électrode de grille 37 est également formée à l'aplomb de la couche de gaz d'électrons 45 entre les électrodes 35 et 62. Une électrode de grille 39 est formée à l'aplomb de la couche de gaz d'électrons 43 entre les électrodes 61 et 36. Une électrode de grille 38 est formée à l'aplomb de la couche de gaz d'électrons 44 entre les électrodes 62 et 36.

Les électrodes de grille 37 et 39 sont connectées à une première borne de l'enroulement secondaire 142, l'électrode de grille 38 est connectée à une deuxième borne de l'enroulement secondaire 142.

Les couches de gaz d'électrons 41 à 45 sont illustrées en pointillés, pour illustrer qu'elles peuvent être formées à partir d'un même substrat et être isolées les unes des autres par des étapes de photolithographie.

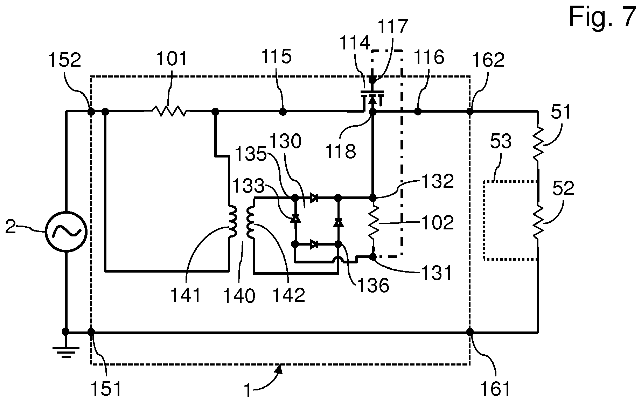

La figure 7 est un schéma électrique d'un exemple d'un troisième mode de réalisation d'un circuit de protection 1. Ce troisième mode de réalisation vise à remplacer transistors 111 et 112 des premier et deuxième modes de réalisation par un transistor bidirectionnel 114, tel que celui décrit dans le document EP2736078. Le troisième mode de réalisation est ici présenté comme une déclinaison du deuxième mode de réalisation mais le transistor bidirectionnel présenté ici peut aussi être utilisé en remplacement des transistors 111 et 112 du premier mode de réalisation.

Le circuit de protection 1 a une entrée connectée à une source de tension alternative 2 et comporte ainsi une entrée comportant des bornes d'entrée 151 et 152. Le circuit de protection 1 a une sortie connectée à un consommateur ou charge électrique 52 et comporte ainsi une sortie comportant des bornes de sortie 161 et 162.

Le circuit de protection 1 comporte un capteur de courant 101 connecté entre la borne d'entrée 152 et la borne de sortie 162, comme détaillé dans les modes de réalisation précédents.

Le circuit de protection 1 comporte également un transistor bidirectionnel 114. Le transistor 114 est de type à effet de champ à haute mobilité électronique, de type normalement fermé. Le transistor 114 inclut de façon connue en soi une couche de gaz d'électrons. Le drain 115 du transistor 114 est connecté à la résistance 101. La source 116 du transistor 114 est connectée à la borne de sortie 162. Le transistor 114 comporte par ailleurs une électrode de référence 118 à l'aplomb de sa couche de gaz d'électrons, entre les électrodes 115 et 116. L'électrode de référence 118 est au potentiel de la couche de la couche de gaz d'électrons située à l'aplomb. Comme décrit dans le document EP2736078, l'électrode 118 est ménagée dans une couche semi-conductrice du transistor 114, et connectée électriquement à la couche de gaz d'électrons située à l'aplomb, soit par connexion directe, soit par connexion par effet tunnel.

Le circuit de protection 1 comporte un transformateur 140 dont l'enroulement primaire 141 est connecté aux bornes de la résistance 101. Le transformateur 140 comporte par ailleurs un enroulement secondaire 142.

Le circuit de protection 1 comporte également un pont redresseur 130 avec des bornes d'entrée 135 et 136 entre lesquelles l'enroulement secondaire 142 est connecté. Le pont redresseur 130 comporte par ailleurs des bornes de sortie 131 et 132, entre lesquelles une résistance 102 est connectée. La résistance 102 peut être constituée d'un transistor à effet de champ à haute mobilité électronique de type normalement ouvert à tension de seuil négative, dont la source et la grille sont connectées. Le pont redresseur 130 comporte quatre diodes de redressement 133, connectées de façon à former un pont de diodes redresseur 130 double alternance.

La grille 117 du transistor 114 est connectée à la borne de sortie 131 du pont redresseur 130. L'électrode de référence 118 est connectée à la borne de sortie 132 du pont redresseur 130. L'électrode de référence 118 applique ainsi un potentiel de référence sur la borne de sortie 132. À partir de ce potentiel, un potentiel est appliqué par la borne de sortie 131 sur la grille 117 du transistor 114.

En fonctionnement normal, le transistor 114 de type normalement fermé est conducteur (sans action extérieure sur la grille 117) et présente une résistance de passage extrêmement réduite, du fait de l'utilisation d'un transistor 114 à haute mobilité électronique. Ainsi, les pertes dans le circuit de protection 1 en l'absence de défaillance sont extrêmement réduites.

## Revendications

1. Circuit de protection (1) d'un consommateur électrique, comportant :
- une interface d'entrée comportant des première et deuxième bornes d'entrée (151, 152) pour l'application d'une différence de potentiel alternative ;
- une interface de sortie comportant des première et deuxième bornes de sortie (161, 162) pour la connexion d'un consommateur électrique ;
- un capteur de courant (101) connecté entre la deuxième borne d'entrée et la deuxième borne de sortie (152, 162) ;
- des premier et deuxième transistors à effet de champ, les premier et deuxième transistors étant connectés en série par l'intermédiaire d'un noeud de connexion (113) ;
- un pont redresseur (130) présentant deux bornes d'entrée (135, 136), et présentant des première et deuxième bornes de sortie (131, 132) entre lesquelles une charge électrique (102) est connectée ;
**Caractérisé en ce que** :
- les premier et deuxième transistors à effet de champ sont des transistors à haute mobilité électronique de type normalement fermé (111, 112) connectés en série avec le capteur de courant entre la deuxième borne d'entrée et la deuxième borne de sortie (152, 162) ;
- le circuit de protection comprend en outre un transformateur (140) dont un enroulement primaire (141) est connecté aux bornes du capteur de courant (101), et comprenant un enroulement secondaire (142) ;
- les bornes d'entrée du pont redresseur (130) sont connectées aux bornes dudit enroulement secondaire (142), la première borne de sortie (131) du pont redresseur (130) étant connectée à une grille de commande du premier transistor et à une grille de commande du deuxième transistor, la deuxième borne de sortie (132) du pont redresseur étant connectée audit noeud de connexion (113).

2. Circuit de protection (1) d'un consommateur électrique selon la revendication 1, dans lequel lesdits premier et deuxième transistors (111, 112) présentent chacun une tension de seuil ayant une amplitude au plus égale à 2V.

3. Circuit de protection (1) d'un consommateur électrique selon la revendication 1 ou 2, dans lequel ledit pont redresseur (130) inclut un pont de diodes.

4. Circuit de protection (1) d'un consommateur électrique selon la revendication 3, dans lequel chaque diode du pont de diodes est constituée d'un transistor à effet de champ à haute mobilité électronique de type normalement ouvert dont la source et la grille sont connectées.

5. Circuit de protection (1) d'un consommateur électrique selon la revendication 4, dans lequel lesdits premier et deuxième transistors et les transistors du pont de diode sont cointégrés sur un même substrat.

6. Circuit de protection (1) d'un consommateur électrique selon l'une quelconque des revendications précédentes, dans lequel ledit capteur de courant (101) est une résistance aux bornes de laquelle ledit enroulement primaire (141) du transformateur (140) est connecté.

7. Circuit de protection (1) d'un consommateur électrique selon la revendication 6, dans lequel ladite résistance (101) présente une valeur de résistance d'au plus 2 Ω.

8. Circuit de protection (1) d'un consommateur électrique selon l'une quelconque des revendications précédentes, dans lequel ladite charge électrique connectée entre lesdites première et deuxième bornes de sortie (131, 132) du pont redresseur (130) est constituée d'une résistance (102).

9. Circuit de protection (1) d'un consommateur électrique selon l'une quelconque des revendications 1 à 7, dans lequel ladite charge électrique connectée entre lesdites première et deuxième bornes de sortie (131, 132) du pont redresseur (130) comprend une résistance (102) connectée en parallèle avec un condensateur (121).

10. Circuit de protection (1) d'un consommateur électrique selon la revendication 8 ou 9, dans lequel ladite résistance (102) est constituée d'un transistor à effet de champ à haute mobilité électronique de type normalement ouvert à tension de seuil négative dont la source et la grille sont connectées .

11. Circuit de protection (1) d'un consommateur électrique selon l'une quelconque des revendications précédentes, dans lequel le rapport de transformation en tension entre l'enroulement primaire et l'enroulement secondaire du transformateur est compris entre 0,5 et 1.

12. Circuit de protection (1) d'un consommateur électrique selon l'une quelconque des revendications précédentes, dans lequel lesdits premier et deuxième transistors (11, 112) incluent une hétérojonction formée à partir d'une couche de GaN.

13. Circuit de protection (1) d'un consommateur électrique, comportant :
- une interface d'entrée comportant des première et deuxième bornes d'entrée (151, 152) pour l'application d'une différence de potentiel alternative ;
- une interface de sortie comportant des première et deuxième bornes de sortie (161, 162) pour la connexion d'un consommateur électrique ;
- un capteur de courant (101) connecté entre la deuxième borne d'entrée et la deuxième borne de sortie (152, 162) ;
- un transistor bidirectionnel (114) à effet de champ, ledit transistor étant connecté en série par des première et deuxième électrodes de conduction (115, 116) entre la deuxième borne d'entrée et la deuxième borne de sortie (152, 162), le capteur de courant (101) mesurant le courant traversant le transistor bidirectionnel ,
- un pont redresseur (130) présentant deux bornes d'entrée (135, 136), et présentant des première et deuxième bornes de sortie (131, 132) entre lesquelles une charge électrique (102) est connectée,
**Caractérisé en ce que** :
- le transistor bidirectionnel est un transistor à haute mobilité électronique de type normalement fermé comportant une couche de gaz d'électrons, ledit transistor bidirectionnel comportant une électrode de référence (118) disposée à l'aplomb de la couche de gaz d'électrons dans une position intermédiaire entre les première et deuxième électrodes de conduction, et l'électrode de référence étant au potentiel de la couche de gaz d'électrons située à son aplomb ;
- le circuit de protection comprend en outre un transformateur (140) dont un enroulement primaire (141) est connecté aux bornes du capteur de courant (101), et comprenant un enroulement secondaire (142) ;
- les bornes d'entrée du pont redresseur (130) sont connectées aux bornes dudit enroulement secondaire (142), la première borne de sortie (131) du pont redresseur (130) étant connectée à une grille de commande (117) du transistor bidirectionnel, la deuxième borne de sortie (132) du pont redresseur étant connectée à ladite électrode de référence (118).

14. Circuit de protection (1) d'un consommateur électrique selon la revendication 13, dans lequel chaque diode du pont de diodes est constituée d'un transistor à effet de champ à haute mobilité électronique de type normalement ouvert dont la source et la grille sont connectées.

15. Circuit de protection (1) d'un consommateur électrique selon la revendication 14, dans lequel ledit transistor bidirectionnel (114) et les transistors du pont de diode sont cointégrés sur un même substrat.

## Patentansprüche

1. Schutzschaltung (1) eines elektrischen Verbrauchers, welche aufweist:
- eine Eingangsschnittstelle, welche eine erste und eine zweite Eingangsklemme (151, 152) zum Anlegen einer Wechselpotentialdifferenz aufweist;
- eine Ausgangsschnittstelle, welche eine erste und eine zweite Ausgangsklemme (161, 162) zum Anschluss eines elektrischen Verbrauchers aufweist;
- einen Stromsensor (101), der zwischen die zweite Eingangsklemme und die zweite Ausgangsklemme (152, 162) geschaltet ist;
- einen ersten und einen zweiten Feldeffekttransistor, wobei der erste und der zweite Transistor über einen Verbindungsknoten (113) in Reihe geschaltet sind;
- eine Gleichrichterbrücke (130), die zwei Eingangsklemmen (135, 136) aufweist und eine erste und eine zweite Ausgangsklemme (131, 132) aufweist, zwischen welche eine elektrische Last (102) geschaltet ist;
**dadurch gekennzeichnet, dass**:
- der erste und der zweite Feldeffekttransistor Transistoren mit hoher elektronischer Mobilität vom normalerweise geschlossenen Typ (111, 112) sind, die mit dem Stromsensor zwischen der zweiten Eingangsklemme und der zweiten Ausgangsklemme (152, 162) in Reihe geschaltet sind;
- die Schutzschaltung außerdem einen Transformator (140) umfasst, von dem eine Primärwicklung (141) mit den Klemmen des Stromsensors (101) verbunden ist und der eine Sekundärwicklung (142) umfasst;
- die Eingangsklemmen der Gleichrichterbrücke (130) mit den Klemmen der Sekundärwicklung (142) verbunden sind, wobei die erste Ausgangsklemme (131) der Gleichrichterbrücke (130) mit einem Steuergate des ersten Transistors und einem Steuergate des zweiten Transistors verbunden ist, wobei die zweite Ausgangsklemme (132) der Gleichrichterbrücke mit dem Verbindungsknoten (113) verbunden ist.

2. Schutzschaltung (1) eines elektrischen Verbrauchers nach Anspruch 1, wobei der erste und der zweite Transistor (111, 112) jeweils eine Schwellenspannung mit einer Amplitude aufweisen, die höchstens gleich 2 V ist.

3. Schutzschaltung (1) eines elektrischen Verbrauchers nach Anspruch 1 oder 2, wobei die Gleichrichterbrücke (130) eine Diodenbrücke enthält.

4. Schutzschaltung (1) eines elektrischen Verbrauchers nach Anspruch 3, wobei jede Diode der Diodenbrücke aus einem Feldeffekttransistor mit hoher elektronischer Mobilität vom normalerweise offenen Typ besteht, dessen Source und Gate verbunden sind.

5. Schutzschaltung (1) eines elektrischen Verbrauchers nach Anspruch 4, wobei der erste und der zweite Transistor und die Transistoren der Diodenbrücke zusammen auf demselben Substrat integriert sind.

6. Schutzschaltung (1) eines elektrischen Verbrauchers nach einem der vorhergehenden Ansprüche, wobei der Stromsensor (101) ein Widerstand ist, an dessen Klemmen die Primärwicklung (141) des Transformators (140) angeschlossen ist.

7. Schutzschaltung (1) eines elektrischen Verbrauchers nach Anspruch 6, wobei der Widerstand (101) einen Widerstandswert von höchstens 2 Ω aufweist.

8. Schutzschaltung (1) eines elektrischen Verbrauchers nach einem der vorhergehenden Ansprüche, wobei die elektrische Last, die zwischen die erste und die zweite Ausgangsklemme (131, 132) der Gleichrichterbrücke (130) geschaltet ist, aus einem Widerstand (102) besteht.

9. Schutzschaltung (1) eines elektrischen Verbrauchers nach einem der Ansprüche 1 bis 7, wobei die elektrische Last, die zwischen die erste und die zweite Ausgangsklemme (131, 132) der Gleichrichterbrücke (130) geschaltet ist, einen Widerstand (102) umfasst, der zu einem Kondensator (121) parallelgeschaltet ist.

10. Schutzschaltung (1) eines elektrischen Verbrauchers nach Anspruch 8 oder 9, wobei der Widerstand (102) aus einem Feldeffekttransistor mit hoher elektronischer Mobilität vom normalerweise offenen Typ mit negativer Schwellenspannung besteht, dessen Source und Gate verbunden sind.

11. Schutzschaltung (1) eines elektrischen Verbrauchers nach einem der vorhergehenden Ansprüche, wobei das Spannungstransformationsverhältnis zwischen der Primärwicklung und der Sekundärwicklung des Transformators zwischen 0,5 und 1 liegt.

12. Schutzschaltung (1) eines elektrischen Verbrauchers nach einem der vorhergehenden Ansprüche, wobei der erste und der zweite Transistor (11, 112) einen Heteroübergang aufweisen, der aus einer GaN-Schicht gebildet ist.

13. Schutzschaltung (1) eines elektrischen Verbrauchers, welche aufweist:
- eine Eingangsschnittstelle, welche eine erste und eine zweite Eingangsklemme (151, 152) zum Anlegen einer Wechselpotentialdifferenz aufweist;
- eine Ausgangsschnittstelle, welche eine erste und eine zweite Ausgangsklemme (161, 162) zum Anschluss eines elektrischen Verbrauchers aufweist;
- einen Stromsensor (101), der zwischen die zweite Eingangsklemme und die zweite Ausgangsklemme (152, 162) geschaltet ist;
- einen bidirektionalen Feldeffekttransistor (114), wobei dieser Transistor über eine erste und eine zweite Leitungselektrode (115, 116) zwischen der zweiten Eingangsklemme und der zweiten Ausgangsklemme (152, 162) in Reihe geschaltet ist, wobei der Stromsensor (101) den Strom misst, der durch den bidirektionalen Transistor fließt;
- eine Gleichrichterbrücke (130), die zwei Eingangsklemmen (135, 136) aufweist und eine erste und eine zweite Ausgangsklemme (131, 132) aufweist, zwischen welche eine elektrische Last (102) geschaltet ist,
**dadurch gekennzeichnet, dass**:
- der bidirektionale Transistor ein Transistor mit hoher elektronischer Mobilität vom normalerweise geschlossenen Typ ist, der eine Elektronengasschicht aufweist, wobei der bidirektionale Transistor eine Referenzelektrode (118) aufweist, die auf einer senkrechten Linie mit der Elektronengasschicht in einer Zwischenposition zwischen der ersten und der zweiten Leitungselektrode angeordnet ist, und wobei die Referenzelektrode auf dem Potential der Elektronengasschicht liegt, die auf einer senkrechten Linie mit ihr angeordnet ist;
- die Schutzschaltung außerdem einen Transformator (140) umfasst, von dem eine Primärwicklung (141) mit den Klemmen des Stromsensors (101) verbunden ist und der eine Sekundärwicklung (142) umfasst;
- die Eingangsklemmen der Gleichrichterbrücke (130) mit den Klemmen der Sekundärwicklung (142) verbunden sind, wobei die erste Ausgangsklemme (131) der Gleichrichterbrücke (130) mit einem Steuergate (117) des bidirektionalen Transistors verbunden ist, wobei die zweite Ausgangsklemme (132) der Gleichrichterbrücke mit der Referenzelektrode (118) verbunden ist.

14. Schutzschaltung (1) eines elektrischen Verbrauchers nach Anspruch 13, wobei jede Diode der Diodenbrücke aus einem Feldeffekttransistor mit hoher elektronischer Mobilität vom normalerweise offenen Typ besteht, dessen Source und Gate verbunden sind.

15. Schutzschaltung (1) eines elektrischen Verbrauchers nach Anspruch 14, wobei der der bidirektionale Transistor (114) und die Transistoren der Diodenbrücke zusammen auf demselben Substrat integriert sind.

## Claims

1. Protection circuit (1) for an electrical consumer, comprising:
- an input interface comprising first and second input terminals (151, 152) for the application of an alternating potential difference;
- an output interface comprising first and second output terminals (161, 162) for the connection of an electrical consumer;
- a current sensor (101) connected between the second input terminal and the second output terminal (152, 162);
- first and second field-effect transistors, the first and second transistors being connected in series by way of a connection node (113);
- a rectifier bridge (130) exhibiting two input terminals (135, 136), and exhibiting first and second output terminals (131, 132) between which an electrical load (102) is connected;
**characterized in that**:
- the first and second field-effect transistors are high electron mobility transistors of normally closed type (111, 112) connected in series with the current sensor between the second input terminal and the second output terminal (152, 162);
- the protection circuit furthermore comprises a transformer (140), a primary winding (141) of which is connected to the terminals of the current sensor (101), and comprising a secondary winding (142);
- the input terminals of the rectifier bridge (130) are connected to the terminals of the said secondary winding (142),the first output terminal (131) of the rectifier bridge (130) being connected to a control gate of the first transistor and to a control gate of the second transistor, the second output terminal (132) of the rectifier bridge being connected to the said connection node (113).

2. Protection circuit (1) for an electrical consumer according to Claim 1, in which the said first and second transistors (111, 112) each exhibit a threshold voltage having an amplitude at most equal to 2 V.

3. Protection circuit (1) for an electrical consumer according to Claim 1 or 2, in which the said rectifier bridge (130) includes a diode bridge.

4. Protection circuit (1) for an electrical consumer according to Claim 3, in which each diode of the diode bridge consists of a high electron mobility field-effect transistor of normally open type whose source and gate are connected.

5. Protection circuit (1) for an electrical consumer according to Claim 4, in which the said first and second transistors and the transistors of the diode bridge are cointegrated on one and the same substrate.

6. Protection circuit (1) for an electrical consumer according to any one of the preceding claims, in which the said current sensor (101) is a resistor across the terminals of which the said primary winding (141) of the transformer (140) is connected.

7. Protection circuit (1) for an electrical consumer according to Claim 6, in which the said resistor (101) exhibits a resistance value of at most 2 Ω.

8. Protection circuit (1) for an electrical consumer according to any one of the preceding claims, in which the said electrical load connected between the said first and second output terminals (131, 132) of the rectifier bridge (130) consists of a resistor (102).

9. Protection circuit (1) for an electrical consumer according to any one of Claims 1 to 7, in which the said electrical load connected between the said first and second output terminals (131, 132) of the rectifier bridge (130) comprises a resistor (102) connected in parallel with a capacitor (121).

10. Protection circuit (1) for an electrical consumer according to Claim 8 or 9, in which the said resistor (102) consists of a high electron mobility field-effect transistor of normally open type with negative threshold voltage whose source and gate are connected.

11. Protection circuit (1) for an electrical consumer according to any one of the preceding claims, in which the voltage transformation ratio between the primary winding and the secondary winding of the transformer lies between 0.5 and 1.

12. Protection circuit (1) for an electrical consumer according to any one of the preceding claims, in which the said first and second transistors (11, 112) include a heterojunction formed on the basis of a GaN layer.

13. Protection circuit (1) for an electrical consumer, comprising:
- an input interface comprising first and second input terminals (151, 152) for the application of an alternating potential difference;
- an output interface comprising first and second output terminals (161, 162) for the connection of an electrical consumer;
- a current sensor (101) connected between the second input terminal and the second output terminal (152, 162);
- a field-effect bidirectional transistor (114), the said transistor being connected in series by first and second conduction electrodes (115, 116) between the second input terminal and the second output terminal (152, 162), the current sensor (101) measuring the current passing through the bidirectional transistor,
- a rectifier bridge (130) exhibiting two input terminals (135, 136), and exhibiting first and second output terminals (131, 132) between which an electrical load (102) is connected,
**characterized in that**:
- the bidirectional transistor is a high electron mobility transistor of normally closed type comprising an electron gas layer, the said bidirectional transistor comprising a reference electrode (118) disposed plumb with the electron gas layer in an intermediate position between the first and second conduction electrodes, and the reference electrode being at the potential of the electron gas layer situated plumb therewith;
- the protection circuit furthermore comprises a transformer (140), a primary winding (141) of which is connected to the terminals of the current sensor (101), and comprising a secondary winding (142);
- the input terminals of the rectifier bridge (130) are connected to the terminals of the said secondary winding (142), the first output terminal (131) of the rectifier bridge (130) being connected to a control gate (117) of the bidirectional transistor, the second output terminal (132) of the rectifier bridge being connected to the said reference electrode (118).

14. Protection circuit (1) for an electrical consumer according to Claim 13, in which each diode of the diode bridge consists of a high electron mobility field-effect transistor of normally open type whose source and gate are connected.

15. Protection circuit (1) for an electrical consumer according to Claim 14, in which the said bidirectional transistor (114) and the transistors of the diode bridge are cointegrated on one and the same substrate.
